# EUROPÄISCHE PATENTSCHRIFT

(11) **EP 0 603 642 B1**
(45) Veröffentlichungstag und Bekanntmachung des Hinweises auf die Patenterteilung: **10.04.1996**
(21) Anmeldenummer: 93119748.7
(22) Anmeldetag: 08.12.1993
(51) Int. Cl.: G03F 3/10, G03F 7/11

(54) **Lichtempfindliches Material und Verfahren zur Herstellung von Farbprüffolien**
Photosensitive material and processes for producing colour-proofing sheets
Matériau photosensible et procédés pour la fabrication d'épreuves de couleurs

(30) Priorität: 19.12.1992 DE 4243253
(43) Veröffentlichungstag der Anmeldung: 29.06.1994
(73) Patentinhaber: HOECHST AKTIENGESELLSCHAFT, D-65926 Frankfurt am Main (DE)
(72) Erfinder: März, Karin, Dr., D-55128 Mainz (DE); Matz, Volker, Dr., D-60529 Frankfurt/M. (DE); Seip, Detlev, Dr., D-65779 Kelkheim/Ts. (DE); Platzer, Stephan J.W., Dr., Califon, New Jersey 07830 (US)

(56) Entgegenhaltungen:
- EP-A- 0 352 055
- EP-A- 0 525 624

## Beschreibung

Die Erfindung betrifft ein lichtempfindliches, insbesondere photopolymerisierbares Material für die Herstellung von Farbprüffolien für den Mehrfarbendruck. Sie betrifft ferner ein Farbprüfverfahren, bei dem auf einem Bildempfangsmaterial ein Mehrfarbenbid aus mehreren Teilfarbenbildern im Register erzeugt wird. Die Teilfarbenbilder werden durch Laminieren einer in einer Grundfarbe des Mehrfarbendrucks eingefärbten photopolymerisierbaren Schicht auf das Bildempfangsmaterial, Belichten unter dem zugehörigen Farbauszug, Entwickeln des Bilds durch Abziehen der Trägerfolie der photopolymerisierbaren Schicht zusammen mit den daran anhaftenden Nichtbildstellen und Wiederholen der gleichen Schritte mit einer photopolymerisierbaren Schicht einer anderen Grundfarbe hergestellt.

Ein derartiges Farbprüfverfahren und ein hierfür vorgesehenes Material sind aus der US-A 4 895 787 bekannt. Dieses Material besteht aus einer transparenten Trägerfolie, deren Oberfläche vorzugsweise haftvermittelnd vorbehandelt worden ist, einer photopolymerisierbaren Schicht, die einen Farbstoff oder ein Farbpigment in einer Grundfarbe des Mehrfarbendrucks enthält und einer thermoplastischen, durch Erwärmen aktivierbaren Haftschicht auf der photopolymerisierbaren Schicht. Das Material wird nach Laminieren auf ein Bildempfangsmaterial durch die Trägerfolie hindurch belichtet und dann durch Auseinanderziehen ("peel apart") von Trägerfolie und Bildempfangsmaterial entwickelt. Dabei verbleiben die belichteten Bereiche der lichtempfindlichen Farbschicht an der Trägerfolie, während die unbelichteten Bereiche zusammen mit der gesamten Haftschicht auf dem Bildempfangsmaterial verbleiben. Das Verfahren arbeitet also positiv.

Dieses Verarbeitungsverfahren hat den großen Vorteil, daß es zur Entwicklung keine alkalischen oder sauren Lösungen und keine organischen Lösemittel erfordert, deren Entsorgung damit entfällt. Ein Nachteil dieses Verfahrens ist ein in den Nichtbildstellen auftretender Hintergrundschleier insbesondere bei Verwendung der Farben Magenta und Gelb. Der Hintergrundschleier wird von Farbstoff- oder -pigmentresten verursacht, die bei einer zu starken Haftung zwischen photopolymerisierter Schicht und Haftschicht nach dem Abziehvorgang auf der Haftschichtoberfläche verbleiben. Eine weitere Ursache für die unerwünschte Färbung der Nichtbildstellen kann die Diffusion des Farbstoffs oder -pigments in die Haftschicht sein, die während der Herstellung des Materials oder während des Laminierens stattfindet.

In der EP-A-0 525 624 (stand der Technik gemäß Art. 54 (3)) ist bereits ein lichtempfindliches Material für die Herstellung von Farbprüffolien für den Mehrfarbendruck mit
A) einer transparenten flexiblen Trägerfolie aus Kunststoff,
B) einer photopolymerisierbaren Schicht, die
   B1) ein polymeres Bindemittel,
   B2) eine radikalisch polymerisierbare Verbindung,
   B3) eine Verbindung, die unter Einwirkung von aktinischem Licht die Polymerisation von (B2) einzuleiten vermag, und
   B4) einen Farbstoff oder ein Farbpigment in einer Grundfarbe des Mehrfarbendrucks enthält, und
C) einer thermoplastischen Haftschicht auf der lichtempfindlichen schicht beschrieben,

bei dem in mindestens einer der Schichten (B) und (C) ein Polymerisat eines Vinylalkylethers enthalten ist. Das Material wird durch Laminieren auf ein Bildempfangsmaterial, Belichten und Auseinanderziehen von Trägerfolie und Bildempfangsmaterial verarbeitet, wobei die unbelichteten Schichtbereiche mit der Haftschicht auf dem Bildempfangsmaterial verbleiben. Diese Schritte werden mit mindestens einem weiteren Teilfarbenbild wiederholt. Das Material ergibt eine bessere Bildauflösung und hat eine bessere Lagerfähigkeit im unbelichteten Zustand.

Aufgabe der Erfindung war es, den in den Nichtbildstellen auftretenden Hintergrundschleier zu reduzieren.

Gegenstand der Erfindung ist ein lichtempfindliches Material für die Herstellung von Farbprüffolien für den Mehrfarbendruck mit
A) einer transparenten, flexiblen Trägerfolie aus Kunststoff,
B) einer photopolymerisierbaren Schicht auf (A), die
   B1) ein polymeres Bindemittel,
   B2) eine radikalisch polymerisierbare Verbindung,
   B3) eine Verbindung, die unter Einwirkung von aktinischem Licht die Polymerisation von (B2) einzuleiten vermag und
   B4) einen Farbstoff oder ein Farbpigment in einer Grundfarbe des Mehrfarbendrucks
   enthält, und
C) einer thermoplastischen Haftschicht.

Das erfindungsgemäße Material ist dadurch gekennzeichnet, daß die Haftschicht (C) mindestens ein Polymerisat enthält, das Einheiten (C1) mit aliphatischen Seitenketten mit mindestens 5 C-Atomen der allgemeinen Formel I 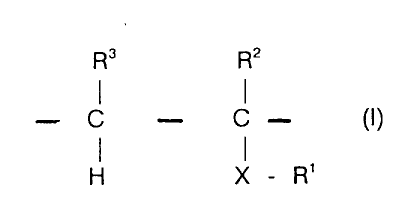 aufweist, worin
- R¹: ein aliphatischer Rest mit mindestens 5 C-Atomen,
- X: 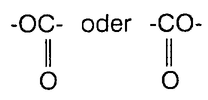
- R: H oder CH₃ und
- R³: H oder eine Alkylgruppe mit 1 oder 2 C-Atomen
ist.

Die Haftschicht (C) zeichnet sich dadurch aus, daß die Haftung zwischen ihr und der photopolymerisierbaren Schicht (B) im Vergleich zu solchen Haftschichten reduziert ist, die die beschriebenen Polymeren nicht enthalten. Durch die verringerte Haftung zwischen (B) und (C) wird der Hintergrundschleier reduziert. Die Wirkung des Polymeren mit Einheiten (C1) kann als die eines internen Gleitmittels aufgefaßt werden.

Erfindungsgemäß wird ferner ein Verfahren zur Herstellung eines Mehrfarbenbilds vorgeschlagen, das darin besteht, daß man ein lichtempfindliches Material der vorstehend definierten Beschaffenheit und Zusammensetzung mit seiner Haftschicht (C) unter Druck auf ein Bildempfangsmaterial laminiert, durch die Trägerfolie hindurch mit einem Farbauszug bildmäßig belichtet, die Trägerfolie zusammen mit den belichteten Bereichen der photopolymerisierbaren Schicht von dem Bildempfangsmaterial abzieht und die Schritte Laminieren, Belichten und Abziehen mit mindestens einem lichtempfindlichen Material einer anderen Grundfarbe und dem zugehörigen anderen Farbauszug wiederholt.

Eine andere Ausführungsform des erfindungsgemäßen Verfahrens besteht darin, daß man eine Haftschicht (C) der vorstehend angegebenen Zusammensetzung auf ein Bildempfangsmaterial aufbringt, ein lichtempfindliches Material aus einer transparenten flexiblen Trägerfolie (A) und einer photopolymerisierbaren Schicht (B) der oben angegebenen Zusammensetzung mit der photopolymerisierbaren Schicht auf die Haftschicht (C) laminiert, die photopolymerisierbare Schicht durch die Trägerfolie hindurch mit einem Farbauszug bildmäßig belichtet, die Trägerfolie zusammen mit den Nichtbildstellen von dem Bildempfangsmaterial abzieht und die Schritte
- Aufbringen einer Haftschicht
- Laminieren eines lichtempfindlichen Materials
- Belichten und
- Abziehen
mit mindestens einem weiteren lichtempfindlichen Material und Farbauszug einer anderen Grundfarbe wiederholt, wobei das Belichten im Register mit dem ersten auf dem Bildempfangsmaterial erzeugten Teilfarbenbild erfolgt.

Die thermoplastische Haftschicht (C) sollte eine Erweichungstemperatur von 40-200° C, vorzugsweise von 60-130° C haben und kann aus einem Dispersionsmittel, Lösemittel oder Lösemittelgemisch aufgebracht werden. Dabei bestehen folgende Möglichkeiten des Vorgehens:
a₁) Die Haftschicht kann direkt auf die photopolymerisierbare Schicht aufgebracht werden, wenn die photopolymerisierbare Schicht durch das verwendete Dispersionsmittel, Lösemittel oder Lösemittelgemisch nicht angelöst wird.
b₁) Die Haftschicht kann auch zuerst auf eine temporäre Trägerfolie aufgebracht und von dort durch Laminieren und anschließendes Abziehen der Trägerfolie auf die photopolymerisierbare Schicht oder das Bildempfangsmaterial übertragen werden. Erfolgt der Übertrag auf das Bildempfangsmaterial, dann wird die photopolymerisierbare Schicht in einem zweiten Schritt auf die so erhaltene Haftschicht laminiert.
c₁) Die Haftschicht kann auf das Bildempfangsmaterial aufgebracht und getrocknet werden. Auf die so erhaltene Haftschicht wird dann die photopolymerisierbare Schicht laminiert.

Das direkte Aufbringen der Haftschicht aus Lösemitteln auf die photopolymerisierbare Schicht wird bevorzugt. Geeignete Lösemittel für die Beschichtung, die die photopolymerisierbare Schicht nicht anlösen, sind Wasser sowie je nach Zusammensetzung der photopolymerisierbaren Schicht aliphatische, alicyclische und aromatische Kohlenwasserstoffe und Alkohole sowie Mischungen hieraus. Typische Beispiele sind Hexan, Cyclohexan, Toluol, Butanol oder Cyclohexanol. Viele Polymere können aus Dispersion aufgebracht werden; das Aufbringen aus Lösung wird aber bevorzugt, wobei sich insbesondere wäßrige Lösungen eignen.

Wesentliches Merkmal der in der thermoplastischen Haftschicht (C) enthaltenen Polymerisate sind seitenständige aliphatische Reste mit mindestens 5, bevorzugt 7 bis 20 Kohlenstoffatomen. Diese Reste können gesättigte oder ungesättigte, bevorzugt gesättigte geradkettige oder verzweigte Kohlenwasserstoffreste sein, die ggf. durch Halogenatome oder niedere Alkoxygruppen, bevorzugt mit 1 bis 4 Kohlenstoffatomen, substituiert sein können.

Das Polymerisat kann ein Homo- oder Copolymerisat von Vinylmonomeren sein, die die genannten seitenständigen Reste enthalten. Copolymerisate mit Einheiten (C1) werden bevorzugt, insbesondere solche, die diese Einheiten in einem Anteil von 5-35 Gew.-% enthalten. Als Vinylmonomere, die die Einheiten (C1) bilden, kommen z. B. Vinylester von aliphatischen Carbonsäuren, z. B. von Capron-, Capryl-, Caprin-, Laurin-, Myristin-, Stearin-, Palmitin-, 4-Methoxy-valerian-, 6-Chlor-pelargon-, 3,4-Dimethyl-heptan-, Versaticsäure oder von Gemischen dieser Säuren, sowie Acrylate oder Methacrylate von einwertigen Alkoholen mit 5 bis 20 Kohlenstoffatomen in Betracht.

In der Haftschicht (C) werden Polymerisate eingesetzt, die Einheiten (C1) der allgemeinen Formel I 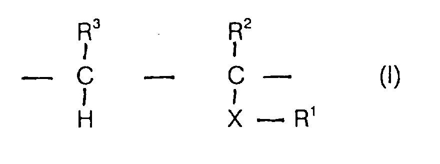 enthalten, worin
- R¹: ein aliphatischer Rest mit mindestens 5 C-Atomen,
- X: 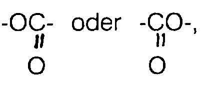
- R: H oder CH₃ und
- R³: H oder eine Alkylgruppe mit 1 oder 2 C-Atomen
ist.

Bevorzugt werden Copolymere aus Einheiten (C1) und (C2), wobei die Einheiten (C2) der allgemeinen Formel II 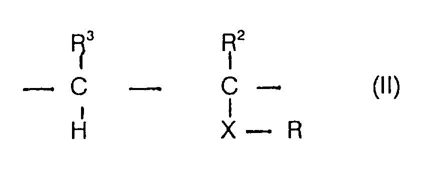 entsprechen, worin
- R: ein aliphatischer Rest mit 1 bis 4,
vorzugsweise 1 oder 2 C-Atomen, ist
und die übrigen Symbole die gleiche Bedeutung wie in Formel I haben.

Beispiele für Verbindungen, die zu Einheiten der Formel II polymerisieren, sind Vinylester wie Vinylacetat, Vinylpropionat, Vinylbutyrat und Vinyl-methoxyacetat; (Meth)acrylsäureester, wie Methylmethacrylat, Ethylacrylat und 2-Chlor-ethylmethacrylat; Crotonsäureester wie Methyl- oder Ethylcrotonat.

Besonders geeignet sind Polymere, die zusätzliche Einheiten (C3) mit Säuregruppen, z. B. Carboxylgruppen bzw. deren Salze enthalten. Beispiele für ungesättigte Carbonsäuren, die zur Bildung von Einheiten (C3) befähigt sind, sind Acrylsäure, Methacrylsäure, Vinylessigsäure und Crotonsäure.

Wenn in der Haftschicht die bevorzugten Terpolymerisate enthalten sind, haben diese vorzugsweise einen Gehalt von 5 bis 35 Gew.-% Einheiten (C1), 45 bis 92 Gew.-% Einheiten (C2) und 3 bis 20 Gew.-% Einheiten (C3). Besonders bevorzugt werden Polymerisate mit 15 bis 30 Gew.-% Einheiten (C1), 55 bis 80 Gew.-% Einheiten (C2) und 3 bis 15 Gew.-% Einheiten (C3). Der Gehalt an Einheiten (C3) ist bevorzugt mindestens so hoch, daß das Polymerisat in wäßrig-alkalischen Lösungen gelöst und aus solcher Lösung aufgebracht werden kann.

Als Bestandteil der Haftschicht (C) werden im allgemeinen solche Terpolymerisate eingesetzt, deren 20 %ige Lösung in Ethylacetat bei 20°C eine Viskosität von 4 bis 12, bevorzugt 5 bis 9 mPas aufweist. Die Viskosität wird mit einem Höppler-Viskosimeter nach DIN 53 015 gemessen und stellt bei sonst gleichen Bedingungen ein Maß für das Molekulargewicht dar.

Der Anteil der Einheiten (C1) in dem in der Haftschicht enthaltenen Polymerisat und dessen Molekulargewicht müssen sorgfältig aufeinander abgestimmt werden. Die aliphatischen Seitenketten der Einheiten (C1) bewirken eine Herabsetzung der Haftung zwischen photopolymerisierbarer Schicht (B) und Haftschicht (C). Durch ihren Mengenanteil und ihre Natur sowie durch das Molekulargewicht des Polymerisats läßt sich die Haftung zwischen den genannten Schichten in gewünschter Weise steuern. Durch die Herabsetzung der Haftung im Vergleich zu bekannten Haftschichten mit Polymeren, die kürzere aliphatische Seitenketten aufweisen, werden alle Eigenschaften positiv beeinflußt, die eine niedrige Haftung zwischen photopolymerisierbarer Schicht (B) und Haftschicht (C) erfordern, insbesondere der Hintergrundschleier und der Glanz des Farbbilds sowie die Handhabbarkeit des Materials bei der peel-apart-Entwicklung.

Die Haftung darf andererseits nicht beliebig herabgesetzt werden, da dann die Auflösung leidet. Diese Wirkung wird durch Herabsetzen des Anteils an Einheiten (C1) im Polymerisat bzw. durch Zusetzen eines Polymerisats, das keine Einheiten (C1) enthält, sowie durch Erhöhen des Molekulargewichts kompensiert. Wie die Beispiele zeigen, läßt sich durch geeignete Wahl der vorstehend genannten Parameter ein Produkt mit dem gewünschten Eigenschaftsspektrum erhalten.

Als Zusatzpolymerisate ohne Einheiten (C1) sind vor allem Copolymerisate aus Einheiten (C2) und (C3) geeignet. Im allgemeinen wird durch Zusatzmengen von etwa 20 bis 50 Gew.-% dieser Copolymerisate, bezogen auf das Gesamtgewicht der Schicht, eine gute Kombination von Eigenschaften erzielt.

Gute Ergebnisse werden auch mit Polymerisaten erhalten, die keine Einheiten (C3) enthalten. Da diese Polymerisate nur in organischen Lösemitteln löslich sind, können Haftschichten mit solchen Polymerisaten im allgemeinen nicht aus Lösung auf die photopolymerisierbare Farbschicht aufgebracht werden, weil die meisten dieser Schichten in organischen Lösemitteln löslich sind. In diesem Fall ist nur das weniger bevorzugte Verfahren möglich, die Haftschicht in einem getrennten Verfahrensschritt auf einer getrennten temporären Trägerfolie herzustellen und von dort durch Laminieren entweder auf die photopolymerisierbare Schicht (B) oder das Bildempfangsmaterial zu übertragen.

Die Haftschicht kann außer dem beschriebenen Polymerisat mit Einheiten (C1) und ggf. einem Copolymerisat aus Einheiten (C2) und (C3) bzw. einem Homopolymerisat aus Einheiten (C2) noch weitere Bestandteile in geringerer Menge, z. B. bis zu etwa 15 Gew.-%, enthalten. Als derartige Zusätze kommen Weichmacher, Haftvermittler, Restlösemittel, Verlaufmittel, Gleitmittel, Antistatika, inerte Füllstoffe, optische Aufheller bzw. UV-Absorber in Betracht. Das Schichtgewicht der Haftschicht liegt im allgemeinen im Bereich von etwa 2 bis 30 g/m und bevorzugt bei 4 bis 15 g/m.

Die photopolymerisierbare Schicht (B) des erfindungsgemäßen Materials enthält als wesentliche Bestandteile ein polymeres Bindemittel (B1), eine radikalisch polymerisierbare Verbindung (B2), eine Verbindung (B3), die bei Einwirkung von aktinischem Licht freie Radikale bildet und damit die Polymerisation der polymerisierbaren Verbindung (B2) einleitet, und einen Farbstoff oder ein Farbpigment (B4) in einer Grundfarbe des Mehrfarbendrucks. Beispiele für photopolymerisierbare Schichten dieser Zusammensetzung sind in der US-A 4 895 787 beschrieben, auf die hier Bezug genommen werden soll.

Das polymere Bindemittel (B1) soll der Schicht Homogenität und Festigkeit verleihen. Geeignete Bindemittel sind Styrol/Maleinsäureanhydrid- und Styrol/ Maleinsäurehalbester-Copolymere, Acrylesterpolymere und -copolymere, Polyamide, Polyvinylpyrrolidone, Cellulosederivate, wie Celluloseester und -ether, Phenolharze, Polyvinylester, Polyvinylacetale, z. B. Polyvinylbutyral, -propional oder -formal. Der Mengenanteil des Bindemittels beträgt im allgemeinen 15 bis 70, vorzugsweise 20 bis 50 Gew.-%, bezogen auf das Gewicht der festen Schicht.

Die polymerisierbare Verbindung (B2) enthält mindestens eine, bevorzugt mindestens zwei endständige radikalisch polymerisierbare Doppelbindungen und ist bei Temperaturen unterhalb 100 °C und bei Normaldruck nicht gasförmig. Bevorzugt werden Ester und Amide der Acryl- und Methacrylsäure. Besonders die Ester mit mehrwertigen Alkoholen werden mit Vorteil eingesetzt. Beispiele sind Di-, Tri-, Tetra- und Polyethylenglykoldi(meth)acrylat, die Di(meth)acrylate von Oligo- und Polypropylenglykolen, 1,4-Butandioldi(meth)acrylat, Trimethylolpropan- und Trimethylolethandi- und -tri(meth)acrylat, Pentaerythrittri- und -tetraacrylat oder -methacrylat, Dipentaerythrittetra-, -penta- und -hexa(meth)acrylat. Der Mengenanteil an polymerisierbarer Verbindung beträgt im allgemeinen 15 bis 70, vorzugsweise 20 bis 60 Gew.-%.

Als Photoinitiatoren (B3) sind im wesentlichen alle für diesen Zweck bekannten Verbindungen oder Verbindungskombinationen geeignet. Beispiele sind Benzoinether, Benzilketale, Mehrkernchinone, Benzophenonderivate, Triarylimidazolyldimere, lichtempfindliche Trihalogenmethylverbindungen, z.B. Trichlormethyl-s-triazine. Besonders bevorzugt werden 2,3-Bis-aryl-chinoxaline, wie sie in der US-A 3 765 898 beschrieben sind, und 2-Aryl-4,6-bis-trichlormethyl-s-triazine. Die Menge an Photoinitiator bzw. an Photoinitiatorkombination liegt im allgemeinen zwischen 1 und 25, vorzugsweise zwischen 5 und 15 Gew.-%.

Die Farbstoffe bzw. Farbpigmente (B4) werden so ausgewählt, daß sie den Grundfarben des Mehrfarbendrucks, Cyan (Blaugrün); Magenta (Purpur); Gelb und Schwarz, entsprechen. Pigmente werden im allgemeinen bevorzugt. Beispiele sind Permanentgelb G (C.I. 21 095), Permanentgelb GR (C.I. 21 100), Permanentgelb DHG (C.I. 21 090), Permanentrubin L3B (C.I. 15 850:1), Permanent Pink F3B (C.I. 12 433), Hostaperm Pink E (C.I. 73 915), Hostaperm Rotviolett ER (C.I. 46 500), Permanentkarmin FBB (C.I. 12 485), Hostapermblau B2G (C.I. 74 160), Hostapermblau A2R (C.I. 74 160) und Printex 25 (Ruß). Die Pigmente können ggf. zur Erzielung des gewünschten Farbtons abgemischt werden. Die anorganischen oder organischen Pigmente werden im allgemeinen zusammen mit einem Teil des Bindemittels in einem geeigneten Lösemittel dispergiert oder angeteigt. Die mittlere Partikelgröße liegt i. a. unterhalb 1 µm, bevorzugt unter 0,2 µm.

Der Mengenanteil des Farbstoffs oder Pigments bzw. der Farbstoff- oder Pigmentmischung beträgt im allgemeinen 8 bis 40 Gew.-%, vorzugsweise 12 bis 30 Gew.-% der photopolymerisierbaren Schicht.

Die photopolymerisierbare Schicht (B) kann ggf. weitere Bestandteile, wie Wasserstoffdonatoren, Sensibilisatoren, Polymerisationsinhibitoren, Weichmacher, Restlöser, Tenside, Oberflächenausgleichsmittel, Gleitmittel, Haftvermittler, Antistatika, inerte Füllstoffe, optische Aufheller und/oder UV-Absorber, enthalten. Sie hat im allgemeinen ein Schichtgewicht von 0,2 bis 5 g/m, bevorzugt 0,3 bis 3 g/m.

Nach dem Trocknen der photopolymerisierbaren Farbschicht wird auf diese in der beschriebenen Weise die thermisch aktivierbare Haftschicht aufgebracht.

Als Trägerfolien werden transparente, flexible, dimensionsstabile Folien aus Kunststoffen, z. B. Polyestern, Polycarbonaten usw., eingesetzt. Besonders bevorzugt werden Polyesterfolien, insbesondere biaxial verstreckte und wärmefixierte Folien, z. B. aus Polyethylenterephthalat. Diese sollten bei den erforderlichen Laminiertemperaturen, d. h. von etwa 60 bis 150 °C maßhaltig bleiben. Ihre Dicke beträgt im allgemeinen 10 bis 200, vorzugsweise 25 bis 80 µm. Die Trägerfolie wird vorteilhaft ein- oder beidseitig haftvermittelnd vorbehandelt und kann eine glatte oder eine rauhe bzw. matte, vorzugsweise eine glatte Oberfläche haben.

Zur Durchführung des erfindungsgemäßen Verfahrens wird das oben beschriebene lichtempfindliche Material mit der Haftschicht auf ein Bildempfangsmaterial laminiert. Dieses kann aus Kunststoff, kunststoffbeschichtetem Spezialpapier oder aus normalem Bedruckpapier bestehen. Andere weiße und ggf. auch nichtweiße Empfangsmaterialien können ebenfalls verwendet werden. Ein unter den Laminierbedingungen maßhaltiges Bedruckpapier wird gewöhnlich bevorzugt, da damit ein dem späteren Druck weitgehend nahekommender visueller Eindruck erzielt wird. Das Laminieren erfolgt zweckmäßig in einem hierfür vorgesehenen Gerät unter Druck und bei erhöhter Temperatur. Die Laminiertemperatur liegt gewöhnlich im Bereich von 60 bis 130, bevorzugt zwischen 80 und 120 °C. Nach dem Laminieren wird die photopolymerisierbare Schicht durch die Trägerfolie hindurch bildmäßig, i. a. im Kontakt unter einem Positiv-Farbauszug in bekannter Weise belichtet. Nach dem Belichten wird die Trägerfolie mit der Hand oder in einer geeigneten Vorrichtung abgezogen. Der Abziehwinkel sollte mindestens 90° betragen, ein Winkel von 180° wird besonders bevorzugt. Dabei werden die belichteten Bereiche der photopolymerisierbaren Schicht mit der Trägerfolie entfernt, während die unbelichteten zusammen mit der gesamten Haftschicht auf dem Bildempfangsmaterial verbleiben. Auf diese Weise wird ein positives Teilfarbenbild erhalten. Jede weitere Farbprüffolie wird in der beschriebenen Weise auf das vorangehende Teilfarbenbild laminiert, vorzugsweise im Register belichtet und durch Abziehen der Trägerfolie entwickelt.

Die Erfindung wird durch die folgenden Beispiele erläutert. Alle Prozentangaben und Mengenverhältnisse sind in Gewichtseinheiten zu verstehen. In den Beispielen 1 und 2 werden lichtempfindliche Materialien mit Haftschichten gemäß dem Stand der Technik beschrieben. Die Beispiele 3 bis 8 dienen zur Veranschaulichung der Vorteile, die sich bei der Verwendung erfindungsgemäßer lichtempfindlicher Materialien ergeben.

Die Charakterisierung der synthetisierten Polymere erfolgt über die Messung der Viskositäten jeweils einer 20 %-igen Lösung in Ethylacetat (bei 20 °C, Höppler Viskosimeter, DIN 53 015), sowie über die Glaspunkte Tg, bestimmt durch Differentialthermoanalyse mit dem Meßgerät Typ 1090 der du Pont de Nemours & Co., Heizrate 20 K/min.

### Beispiel 1 (Vergleichsbeispiel)

Die Beschichtungslösungen für die photopolymerisierbaren Schichten bestehen aus folgenden Komponenten in Gewichtsteilen:

| Bestandteil: | Gewichtsteile: | | | |
|---|---|---|---|---|
| | Cyan | Magenta | Gelb | Schwarz |
| Dipentaerythritpentaacrylat | 39.0 | 35.5 | 38.2 | 36.1 |
| 2-Diphenylyl-(4)-4,6-bis-trichlormethyl-s-triazin | 9.8 | 7.8 | 9.5 | 9.6 |
| Polyvinylformal (Formvar^{(R)} 12/85) | 31.3 | 36.5 | 35.4 | 28.0 |
| Hostaperm^{(R)} Blau B2G (C.I. 74160) | 19.0 | - | - | - |
| Permanentcarmin FBB (C.I. 12485) | - | 18.5 | - | - |
| Permanentgelb GR (C.I. 21100) | - | 0.7 | 16.4 | - |
| Ruß (Printex^{(R)} 25) | 0.4 | 0.5 | - | 24.8 |
| Silikonöl (Edaplan^{(R)} LA 411) | 0.5 | 0.5 | 0.5 | 0.6 |

Jedes der vier Gemische wurde in einem Lösemittelgemisch aus 1000 Gt Tetrahydrofuran, 680 Gt 1-Methoxy-2-propanol und 190 Gt gamma-Butyrolacton gelöst.

Die Pigmente werden zuvor mit einem Teil des Bindemittels und des Butyrolactons dispergiert. Die mittlere Teilchengröße liegt unterhalb von 0,2 µm. Die Dispersion und die übrigen Bestandteile werden gemischt und auf eine 50 µm dicke biaxial verstreckte und thermofixierte Polyethylenterephthalatfolie aufgetragen, die auf beiden Seiten zur Haftverbesserung vorbehandelt worden ist (Melinex ^{(R)} 505). Die Schichten werden bei 70 °C getrocknet. Die Schichtgewichte liegen zwischen 0,6 und 0,8 g/m.

Die Haftschichtlösung setzt sich wie folgt zusammen:

| Bestandteil | Gt |
|---|---|
| Vinylacetat/Crotonsäure-Copolymeres 95:5 (Mowilith^{(R)} Ct5) | 96.6 |
| Polyvinylmethylether (Lutonal^{(R)} M40) | 1.9 |
| Natriumsulfit | 1.4 |
| Wasser | 520.0 |
| Ethanol | 43.0 |
| Ammoniakwasser, 25 %-ig | 8.5 |

Die Lösung wird auf die trockenen photopolymerisierbaren Schichten aufgetragen. Nach der Trocknung beträgt das Schichtgewicht der Haftschicht 6.5 g/m.

Eine der so hergestellten Folien, z. B. die Cyan-Farbfolie, wird bei 85 °C auf kunststoffbeschichtetes Spezialpapier laminiert und unter dem Cyan-Farbauszugsfilm belichtet. Die Trägerfolie wird kontinuierlich in einem Winkel von 180° von Hand abgezogen. Auf dem Papier verbleiben die Haftschicht und das positive Cyan-Bild, auf das nacheinander die weiteren photopolymerisierbaren Farbschichten laminiert und in gleicher Weise verarbeitet werden.

### Beispiel 2 (Vergleichsbeispiel)

Die Zusammensetzung der Beschichtungslösungen für die photopolymerisierbaren Schichten stimmt mit Beispiel 1 überein, aber der Photoinitiator wird jeweils gegen die gleiche Menge 2,3-Bis-(4-methoxyphenyl)chinoxalin ausgetauscht. Die Zusammensetzung der Haftschichtlösung und die weitere Verarbeitung ändern sich nicht.

In beiden Vergleichsbeispielen kann für alle Farben in einem Raster von 60 Linien/cm ein Tonwertumfang von 2 bis 98 % erreicht werden, d. h. es werden die Rasterpunkte, deren Größe der angegebenen Flächendeckung in % entspricht, noch wiedergegeben. Als Maß für die Hintergrundfärbung wird die optische Dichte in den Nichtbildstellen mit einem Densitometer ermittelt. Dazu wird eine Farbfolie in der beschriebenen Weise auf das Empfangsblatt laminiert und bei der zuvor ermittelten optimalen Belichtungszeit, d. h. der Belichtungszeit, bei der der größte Tonwertumfang erreicht wird, belichtet. Um den Meßeffekt zu verstärken, wird der Vorgang nach dem Abziehen der Trägerfolie noch dreimal mit Farbfolien der gleichen Farbe wiederholt. Als Referenz für die Messung der Hintergrundfärbung dient die optische Dichte (D) der Bildempfangsblattes ohne Prüfbild, die den Wert Null zugewiesen bekommt. Für die Farben Cyan (C), Magenta (M), Gelb (Y) und Schwarz (K) werden bei jeweils vier Lagen folgende optische Dichten (D) für den Bildhintergrund gemessen:

| 1 | C | M | Y | K | 2 | C | M | Y | K |
|---|---|---|---|---|---|---|---|---|---|
| D | 0.03 | 0.07 | 0.08 | 0.00 | D | 0.03 | 0.07 | 0.13 | 0.00 |

Die hohen optischen Dichten für Magenta und Gelb zeigen, daß der Hintergrundschleier eines vierfarbigen Prüfbildes in erster Linie auf diese beiden Farben zurückzuführen ist. Dichtewerte von mehr als 0.02 sind schon deutlich visuell wahrzunehmen und stören damit den für ein Farbprüfverfahren entscheidenden Farbeindruck.

### Beispiel 3:

150 Gt einer Lösung, bestehend aus 20,7 Gt tert.-Butylperoxy-2-ethylhexanoat, 743 Gt Vinylacetat, 318 Gt Vinyl-C₉-alkanoat (Veova^{(R)}9), 60 Gt Crotonsäure und 66 Gt Isopropanol werden bei 70 °C anpolymerisiert. Bei Erreichen von 78 °C wird die restliche Monomerlösung innerhalb von vier Stunden zudosiert. Nach einer Nachpolymerisationsphase von einer Stunde wird das Lösemittel abdestilliert. Das Polymer wird nach dem Erkalten granuliert. Es wird als Terpolymer Nr. 1 bezeichnet und enthält die folgenden Monomeranteile:

| | |
|---|---|
| Vinylacetat | 66.5 % |
| Veova 9 | 28.5 % |
| Crotonsäure | 5.0 % |

Viskosität (20 %-ige Lösung d. Polymeren in Ethylacetat): 9.16 mPas
Glaspunkt (Tg): 37 °C

Auf die photopolymerisierbare Schicht von Farbfolien der Farben Gelb und Magenta aus Beispiel 1 wird jeweils folgende Haftschichtlösung aufgetragen und getrocknet:

| Bestandteil | Gt |
|---|---|
| Terpolymer Nr. 1 | 96.6 |
| Lutonal M 40 | 1.9 |
| Natriumsulfit | 1.4 |
| Wasser | 520.0 |
| Ethanol | 43.0 |
| Ammoniakwasser, 25 %-ig | 8.5 |

Das Schichtgewicht der trockenen Haftschicht beträgt 6.5 g/m.

Die so erhaltenen Farbprüffolien werden in der unter Beispiel 1 beschriebenen Weise jeweils zu einem einfarbigen, vierlagigen Bild verarbeitet. Der Tonwertumfang beträgt 4 bis 96 %. Für den Hintergrundschleier werden die folgenden optischen Dichten (D) gemessen:

| | M | Y |
|---|---|---|
| D | 0.02 | 0.06 |

Für Magenta kann im Vergleich zu den Beispielen 1 und 2 eine signifikante, für Gelb eine geringe Reduzierung des Hintergrundschleiers erreicht werden.

### Beispiel 4

Für die Haftschicht wird ein Terpolymer (Nr. 2) verwendet, das die gleiche Zusammensetzung hat wie das Terpolymer Nr. 1, aber ein geringeres Molekulargewicht:

Viskosität (20 %-ige Lösung d. Polymeren in Ethylacetat): 5.52 mPas Glaspunkt: 36 °C

Die Haftschichtlösung, die auf die photopolymerisierbare Schicht von Farbfolien der Farben Magenta und Gelb aus Beispiel 1 aufgebracht wird, hat folgende Zusammensetzung:

| Bestandteil | Gt |
|---|---|
| Terpolymer Nr. 2 | 96.6 |
| Lutonal^{(R)} M 40 | 1.9 |
| Natriumsulfit | 1.4 |
| Wasser | 520.0 |
| Ethanol | 43.0 |
| Ammoniakwasser, 25 %-ig | 8.5 |

Das Schichtgewicht der trockenen Haftschicht beträgt 6.5 g/m.

Die so erhaltenen Farbprüffolien werden in der unter Beispiel 1 beschriebenen Weise jeweils zu einem einfarbigen, vierlagigen Bild verarbeitet.

| | M | Y |
|---|---|---|
| D | 0.01 | 0.02 |
| Tonwertumfang | 10-85 % | 4-95 % |

Die Verwendung des Terpolymeren Nr. 2 ergibt eine besonders wirksame Reduktion des Hintergrundschleiers. Die Haftung zwischen photopolymerisierbarer Schicht und Haftschicht nimmt allgemein mit dem Molekulargewicht des in der Haftschicht enthaltenen Polymeren ab. Eine zu geringe Haftung zwischen photopolymerisierbarer Schicht und Haftschicht führt jedoch, wie das Beispiel 4 zeigt, zu einem für Farbprüfverfahren nicht mehr ausreichenden Tonwertumfang.

### Beispiel 5

Auf die photopolymerisierbare Schicht einer Magenta-Farbfolie aus Beispiel 1 wird die folgende Haftschichtlösung aufgetragen und getrocknet:

| Bestandteil | Gt |
|---|---|
| Terpolymer Nr. 2 | 64.4 |
| Mowilith Ct 5 | 32.2 |
| Lutonal^{(R)}M 40 | 1.9 |
| Natriumsulfit | 1.4 |
| Wasser | 520.0 |
| Ethanol | 43.0 |
| Ammoniakwasser, 25 %-ig | 8.5 |

Das Schichtgewicht der trockenen Haftschicht beträgt 6.5 g/m.

Die so erhaltenen Farbprüffolien werden in der unter Beispiel 1 beschriebenen Weise jeweils zu einem einfarbigen, vierlagigen Bild verarbeitet. Die optische Dichte des Bildhintergrundes beträgt bei dem aus vier Lagen bestehenden Einfarbenbild D = 0.02, der Tonwertumfang 2 bis 97 %.

### Beispiel 6

Wie in Beispiel 3 beschrieben, wird das Terpolymer Nr. 3 aus den folgenden Ausgangssubstanzen hergestellt:

| | | |
|---|---|---|
| Monomeranteile: | Vinylacetat | 76.0 % |
| | Veova^{(R)} 9 (Vinyl-C₉-alkanoat) | 19.0 % |
| | Crotonsäure | 5.0 % |
| Viskosität (20 %-ige Lösung d. Polymeren in Ethylacetat): | | 9.20 mPas |
| Glaspunkt: 39 °C | | |

Zusammensetzung der Haftschichtlösung:

| Bestandteil | Gt |
|---|---|
| Terpolymer Nr. 3 | 96.6 |
| Lutonal^{R}M 40 | 1.9 |
| Natriumsulfit | 1.4 |
| Wasser | 520.0 |
| Ethanol | 43.0 |
| Ammoniakwasser, 25 %-ig | 8.5 |

Die Haftschichtlösung wird auf die photopolymerisierbare Schicht von Farbfolien der Farben Magenta und Gelb aus den Beispielen 1 und 2 aufgetragen und getrocknet. Das Schichtgewicht der trockenen Haftschicht beträgt 6.5 g/m.

Wie in Beispiel 1 ausführlich beschrieben, werden einfarbige Bilder, die aus vier Lagen der betreffenden Farbe bestehen, hergestellt. Für den Hintergrundschleier der Nichtbildstellen werden die folgenden optischen Dichten gemessen:

| 1 | M | Y | 2 | M | Y |
|---|---|---|---|---|---|
| D | 0.02 | 0.06 | D | 0.02 | 0.08 |

Der Tonwertumfang beträgt in beiden Fällen 2 - 98 %. Bei gleicher Reduktion des Hintergrundschleiers wie in Beispiel 3 ist hier der Tonwertumfang größer und entspricht der Qualität aus den Beispielen 1 und 2.

### Beispiel 7

Ein Terpolymeres wird analog der in Beispiel 3 angegebenen Vorschrift aus den folgenden Komponenten hergestellt und als Terpolymer Nr. 4 bezeichnet:

| | | |
|---|---|---|
| Monomeranteile: | Vinylacetat | 76.0 % |
| | ®Veova 10 (Vinyl-C₁₀-alkanoat) | 19.0 % |
| | Crotonsäure | 5.0 % |
| Viskosität (20 %-ige Lösung d. Polymeren in Ethylacetat): | | 9.10 mPas |
| Glaspunkt: 41 °C | | |

Zusammensetzung der Haftschichtlösung:

| Bestandteil | Gt |
|---|---|
| Terpolymer Nr. 4 | 96.6 |
| ®Lutonal M 40 | 1.9 |
| Natriumsulfit | 1.4 |
| Wasser | 520.0 |
| Ethanol | 43.0 |
| Ammoniakwasser, 25 %-ig | 8.5 |

Die Haftschichtlösung wird auf die photopolymerisierbare Schicht von Farbfolien der Farbe Magenta aus Beispiel 1 aufgetragen und getrocknet. Das Schichtgewicht der trockenen Haftschicht beträgt 6.5 g/m.

Wie in Beispiel 1 ausführlich beschrieben, werden einfarbige Bilder, die aus vier Lagen der betreffenden Farbe bestehen, hergestellt. Für den Hintergrundschleier der Nichtbildstellen wird eine optische Dichte von D = 0.03 gemessen, der Tonwertumfang beträgt 2 bis 98 %.

### Beispiel 8

Es wird eine Haftschichtlösung der folgenden Zusammensetzung auf eine bei Hitze dimensionsstabile Trägerfolie (Polyesterfolie von ICI, Typ Melinex 516, Dicke: 50 µm) aufgebracht und getrocknet:

| Bestandteil | Gt |
|---|---|
| Copolymer Vinylacetat/Vinyllaurat 80:20 (Vinnapas^{(R)} B100/20VL) | 10.0 |
| Polyvinylacetat (Vinnapas^{(R)} B100) | 10.0 |
| n-Butylacetat | 80.0 |
| Das Schichtgewicht der trockenen Haftschicht beträgt 6 g/m. | |

Diese Haftfolie wird bei 85 °C auf ein Empfangsblatt aus Papier laminiert. Die Trägerfolie wird abgezogen, die Haftschicht verbleibt auf dem Empfangsblatt. Auf diese Schicht wird eine haftschichtfreie Magenta-Farbfolie gemäß Beispiel 1 - ebenfalls bei 85 °C - laminiert und unter dem entsprechenden Farbauszug belichtet. Nach dem Abziehen der Farbschicht-Trägerfolie erhält man das Einzelbild für die Farbe Magenta. Diese Vorgehensweise wird wiederholt, bis man auch in diesem Beispiel vier übereinanderliegende Einzelbilder vorliegen hat. Die optische Dichte des Bildhintergrundes beträgt D = 0.02, der Tonwertumfang 2 - 98 %.

## Patentansprüche

1. Lichtempfindliches Material für die Herstellung von Farbprüffolien für den Mehrfarbendruck mit
A) einer transparenten, flexiblen Trägerfolie aus Kunststoff,
B) einer photopolymerisierbaren Schicht auf (A), die
B1) ein polymeres Bindemittel,
B2) eine radikalisch polymerisierbare Verbindung,
B3) eine Verbindung, die unter Einwirkung von aktinischem Licht die Polymerisation von (B2) einzuleiten vermag und
B4) einen Farbstoff oder ein Farbpigment in einer Grundfarbe des Mehrfarbendrucks
enthält und
C) einer thermoplastischen Haftschicht,
dadurch gekennzeichnet, daß die Haftschicht (C) mindestens ein Polymerisat enthält, das Einheiten (C1) mit aliphatischen Seitenketten mit mindestens 5 C-Atomen der allgemeinen Formel I 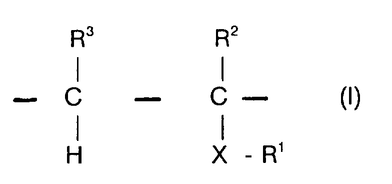 aufweist, worin
R¹ ein aliphatischer Rest mit mindestens 5 C-Atomen,
X 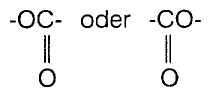
R H oder CH₃ und
R³ H oder eine Alkylgruppe mit 1 oder 2 C-Atomen
ist.

2. Lichtempfindliches Material nach Anspruch 1, dadurch gekennzeichnet, daß das in der Haftschicht (C) enthaltene Polymerisat ein Copolymerisat aus Einheiten (C1) und Einheiten (C2) der allgemeinen Formel II 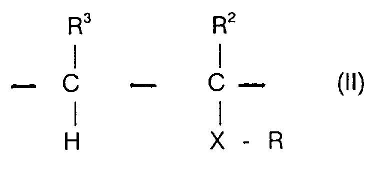 ist, worin
R ein aliphatischer Rest mit 1 bis 4 C-Atomen ist
und die übrigen Symbole die in Anspruch 1 angegebene Bedeutung haben.

3. Lichtempfindliches Material nach Anspruch 1 oder 2, dadurch gekennzeichnet, daß das in der Haftschicht (C) enthaltene Polymerisat zusätzlich Einheiten (C3) enthält, die aus einer α,β-ungesättigten Carbonsäure entstanden sind.

4. Lichtempfindliches Material nach Anspruch 1, dadurch gekennzeichnet, daß die Verbindung, aus der die Einheiten (C1) entstanden sind, ein Vinylester einer mindestens 6 C-Atome enthaltenden Monocarbonsäure, oder ein Acryl- oder Methacrylsäureester eines einwertigen, mindestens 5 C-Atome enthaltenden Alkohols ist.

5. Lichtempfindliches Material nach Anspruch 1, dadurch gekennzeichnet, daß die thermoplastische Haftschicht (C) ein Schichtgewicht von 2 bis 30 g/maufweist.

6. Verfahren zur Herstellung eines Mehrfarbenbilds, dadurch gekennzeichnet, daß man ein lichtempfindliches Material nach Anspruch 1 mit seiner Haftschicht (C) unter Druck auf ein Bildempfangsmaterial laminiert, durch die Trägerfolie hindurch mit einem Farbauszug bildmäßig belichtet, die Trägerfolie zusammen mit den belichteten Schichtbereichen von dem Bildempfangsmaterial abzieht und die Schritte Laminieren, Belichten und Abziehen mit mindestens einem lichtempfindlichen Material einer anderen Grundfarbe und dem zugehörigen anderen Farbauszug wiederholt.

7. Verfahren zur Herstellung eines Mehrfarbenbilds, dadurch gekennzeichnet, daß man eine Haftschicht (C) der in Anspruch 1 angegebenen Zusammensetzung auf ein Bildempfangsmaterial aufbringt, ein lichtempfindliches Material aus einer transparenten flexiblen Trägerfolie (A) und einer photopolymerisierbaren Schicht (B) der in Anspruch 1 angegebenen Zusammensetzung mit der photopolymerisierbaren Schicht auf die Haftschicht (C) laminiert, die photopolymerisierbare Schicht durch die Trägerfolie hindurch mit einem Farbauszug bildmäßig belichtet, die Trägerfolie zusammen mit den Nichtbildstellen von dem Bildempfangsmaterial abzieht und die Schritte
- Aufbringen einer Haftschicht
- Laminieren eines lichtempfindlichen Materials
- Belichten und
- Abziehen
mit mindestens einem weiteren lichtempfindlichen Material und einem Farbauszug einer anderen Grundfarbe wiederholt, wobei das Belichten im Register mit dem ersten auf dem Bildempfangsmaterial erzeugten Teilfarbenbild erfolgt.

## Claims

1. A photosensitive material for making color-proofing films for multicolor printing with
A) a transparent flexible support film of plastic,
B) a photopolymerizable layer on (A) comprising
B1) a polymeric binder,
B2) a compound polymerizable by a free-radical mechanism,
B3) a compound which is capable of initiating the polymerization of (B2) under the action of actinic light and
B4) a dye or a color pigment in a primary color of the multicolor print, and
C) a thermoplastic adhesive layer,
wherein the adhesive layer (C) comprises at least one polymer which contains units (C1) with aliphatic side chains having at least 5 carbon atoms of the formula 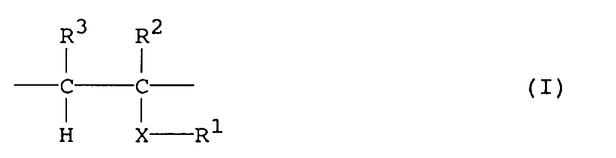 in which
R¹ is an aliphatic radical having at least 5 carbon atoms,
X is 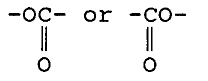
R is H or CH₃ and
R³ is H or an alkyl group having 1 or 2 carbon atoms.

2. A photosensitive material as claimed in claim 1, wherein the polymer present in the adhesive layer (C) is a copolymer of units (C1) and units (C2) if the formula II 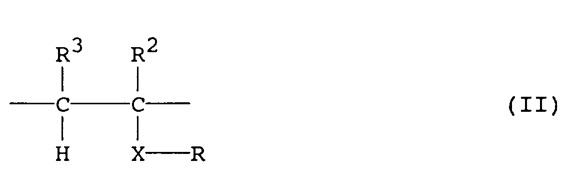 in which
R is an aliphatic radical having 1 to 4 carbon atoms and
the other symbols are as defined in claim 1.

3. A photosensitive material as claimed in claim 1 or 2, wherein the polymer present in the adhesive layer (C) additionally contains units (C3) which have been formed from an α,β-unsaturated carboxylic acid.

4. A photosensitive material as claimed in claim 1, wherein the compound, from which the units (C1) have been formed, is a vinyl ester of a monocarboxylic acid containing at least 6 carbon atoms or an acrylate or methacrylate of a monohydric alcohol containing at least 5 carbon atoms.

5. A photosensitive material as claimed in claim 1, wherein the thermoplastic adhesive layer (C) has a layer weight from about 2 to about 30 g/m.

6. A method for making a multicolor image, which comprises laminating a photosensitive material as claimed in claim 1 by its adhesive layer (C) under pressure to an image receptor sheet, imagewise exposing through the support film under a color separation, peeling the support film together with the exposed layer areas off from the image receptor sheet and repeating the steps of laminating, exposure and peeling-off with at least one photosensitive material of another primary color and the respective other color separation.

7. A method for making a multicolor image, which comprises applying an adhesive layer (C) of the composition given in claim 1 to an image receptor sheet, laminating a photosensitive material composed of a transparent flexible support film (A) and a photopolymerizable layer (B) of the composition given in claim 1 by the photopolymerizable layer to the adhesive layer (C), imagewise exposing the photopolymerizable layer through the support under a color separation, peeling the support together with the non-image areas off from the image receptor sheet and repeating the steps of
- applying an adhesive layer,
- laminating a photosensitive material,
- exposure and
- peeling off
with at least one further photosensitive material and a color separation of another primary color, the exposure taking place in register with the first image produced on the image receptor sheet.

## Revendications

1. Matériau photosensible pour la fabrication d'épreuves de couleur pour l'impression polychrome comprenant :
A) une feuille de support en matière plastique, flexible, transparente,
B) une couche photopolymérisable placée sur (A), qui contient
B1) un liant polymère,
B2) un composé polymérisable par voie radicalaire,
B3) un composé susceptible de déclencher la polymérisation de (B2) sous l'action de lumière actinique, et
B4) un colorant ou un pigment coloré d'une couleur de base de l'impression polychrome,
et
C) une couche adhésive thermoplastique,
caractérisé en ce que la couche adhésive (C) contient au moins un produit de polymérisation, qui présente des motifs (C1) avec des chaînes latérales aliphatiques comportant au moins 5 atomes de carbone de formule générale I 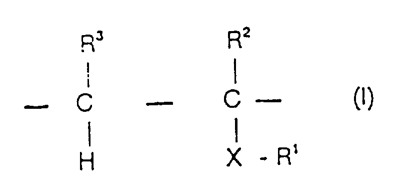 dans laquelle
R¹ représente un radical aliphatique comportant au moins cinq atomes de carbone,
X représente 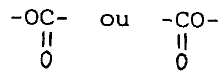
R représente H ou CH₃ et
R³ représente H ou un groupe alkyle comportant un ou deux atomes de carbone.

2. Matériau photosensible selon la revendication 1, caractérisé en ce que le produit de polymérisation contenu dans la couche adhésive (C) est un produit de copolymérisation de motifs (C1) et de motifs (C2) de formule générale 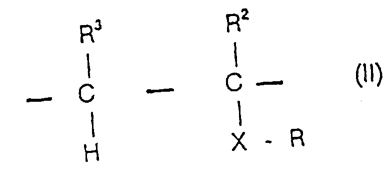 dans laquelle,
R représente un radical aliphatique comportant un à quatre atomes de carbone et les autres symboles ont la signification donnée dans la revendication 1.

3. Matériau photosensible selon la revendication 1 ou 2, caractérisé en ce que le produit de polymérisation contenu dans la couche adhésive (C) contient en outre des motifs (C3) supplémentaires qui dérivent d'un acide carboxylique α,β-insaturé.

4. Matériau photosensible selon la revendication 1, caractérisé en ce que le composé dont dérivent les motifs (C1) est un ester vinylique d'un acide monocarboxylique contenant au moins six atomes de carbone, ou un ester acrylique ou méthacrylique d'un alcool monovalent contenant au moins cinq atomes de carbone.

5. Matériau photosensible selon la revendication 1, caractérisé en ce que la couche adhésive thermoplastique (C) présente un poids de couche de 2 à 30 g/m.

6. Procédé d'obtention d'une image polychrome, caractérisé en ce qu'on lamine un matériau photosensible selon la revendication 1 avec sa couche adhésive (C) appliquée sous pression sur un matériau de réception d'images, on insole suivant une image avec une sélection chromatique à travers la feuille de support, on retire du matériau de réception d'images la feuille de support avec les domaines de couche insolés et on répète l'étape de laminage, insolation et séparation avec au moins un matériau photosensible d'une autre couleur de base et avec l'autre sélection chromatique correspondante.

7. Procédé d'obtention d'une image polychrome, caractérisé en ce que l'on dépose une couche adhésive (C) de la composition présentée dans la revendication 1 sur un matériau de réception d'images, on lamine sur la couche adhésive (C) un matériau photosensible constitué d'une feuille de support (A) flexible et transparente et d'une couche photopolymérisable (B) de la composition présentée dans la revendication 1,on insole la couche photopolymérisable suivant une image avec une sélection chromatique à travers la feuille de support, on retire la feuille de support avec les zones de non-image du matériau de réception d'images, et l'on répète les étapes:
- dépôt d'une couche adhésive,
- laminage d'un matériau photosensible,
- insolation et,
- séparation
avec au moins un autre matériau photosensible et une sélection chromatique d'une autre couleur de base, l'insolation se faisant en respectant les repères de la première image partielle en couleur produite sur le matériau de réception d'images.
